# EUROPEAN PATENT APPLICATION

(11) **EP 4 657 752 A1**
(43) Date of publication of application: **03.12.2025**
(21) Application number: 25178989.7
(22) Date of filing: 27.05.2025
(51) Int. Cl.: H03F 1/32, H03F 1/34, H03F 3/185, H03F 3/217, H03F 3/45

(54) **IMPROVED SELF-OSCILLATING CLASS-D AMPLIFIER DEVICE**

(30) Priority: 28.05.2024 NL 2037806
(71) Applicant: Hypex Holding B.V., 9723 JP Groningen (NL)
(72) Inventor: VELDMAN, Frank Derk, GRONINGEN (NL); KALTOFEN, Rudolf Edmund, GRONINGEN (NL)
(74) Representative: Algemeen Octrooi- en Merkenbureau B.V.

(57) **Abstract**

The present disclosure relates to an amplifier device for amplifying an input signal Sx at a device input X to an output signal Sy at a device output Y, for driving a loudspeaker or comparable reactive load, comprises a self-oscillating Class D power amplifier stage with transfer function KA(s). The amplifier stage includes a comparator, a power stage, and a second-order low-pass output filter comprising an inductor and a capacitor. A time delay unit provides a delay determined by one or more of the comparator, the power stage, and a first feedback filter. The output signal Sy is fed back to the comparator via the first feedback path to establish oscillation and provide basic low-frequency feedback. A correction stage is provided, comprising a second feedback path that feeds the output signal Sy, via a scaling resistor, to a virtual ground input of a transimpedance amplifier. This enables pre-distortion of the amplifier input SKin by subtracting a filtered distortion component derived from a tracking filter. To further enhance correction, a third feedback path is included. It comprises a passive network applying a first transfer function H2 to the output signal Sy and a second, distinct transfer function H3 to the input signal Sx. The resulting signals are summed as current into a transimpedance amplifier, the output of which defines signal Sr as the corrected reference signal for the correction stage.

## Description

### Field of the invention

The present invention is directed to an amplifier device, and in particular to an amplifier device with improved audio quality

### Background of the invention

The field of audio amplification has seen significant advancements in recent years, with the development of high-performance class D amplifiers. Class D amplifiers, also known as switching amplifiers, are electronic amplifiers in which the power stage semiconductors, usually transistors such as MOSFETs, operate as electronic switches, and not as linear gain devices as in older, conventional, amplifiers. They work by generating a train of rectangular pulses of fixed amplitude but varying duty cycle, representing the amplitude variations of the analogue audio input signal. The output of the modulator is then used to turn the output transistors on and off alternately. Since the transistors are either fully on or fully off, they dissipate very little power, which is a typical advantage of class D amplifiers. A low-pass filter consisting of an inductor and a capacitor provides a path for the audible low frequencies of the audio signal, removing most of the high-frequency content from the audio signal.

Class D amplifiers have been known for quite some time and are known for having, as compared to other classes of amplifiers, several advantages, amongst which, that they have always offered better efficiency compared to Class A or class AB amplifiers, and for their relatively compact size. They however also face certain challenges, like possible EMC related issues.

The complexity of the control circuitry in Class D amplifiers can pose challenges in terms of design and implementation. Achieving a balance between efficiency, size, and maintaining low distortion requires careful engineering and often involves trade-offs. Furthermore, the sensitivity of some Class D amplifiers to load variations can be a concern. Reactive loads can impact performance, making it important to design the amplifier to perform well under widely varying load conditions.

Modern high performance Class D amplifiers however perform well in most applications, and often feature high-fidelity characteristics in which many of the above mentioned drawbacks of typical Class D amplifiers have been overcome to a certain extent.

But even modern Class D amplifiers are not always without compromises and often still leave room for improvement.

Over the years, several improvements have been made to enhance the fidelity and robustness of Class D amplifiers, including feedback control techniques and improved component integration. Despite these advances, many commercially available Class D designs still leave room for further improvement, particularly in maintaining high audio quality under real-world dynamic conditions and with reactive loads.

In particular, balancing the trade-offs between efficiency, distortion suppression, and control loop stability remains a design challenge, especially as higher fidelity demands are placed on these amplifiers in high-end audio applications.

As such, the present invention has for its object to provide an improved self-oscillating Class D amplifier device, that offers enhanced audio performance, reduced distortion, and improved stability, while maintaining the inherent efficiency advantages of Class D operation.

### Summary

The above mentioned object has been achieved, at least in part, in a first aspect of the present disclosure, by an amplifier device for amplifying an input signal Sx at a device input X to an output signal Sy at a device output Y, for driving a loudspeaker or a comparable reactive load, said amplifier device comprising:
- a self oscillating Class D power amplifier stage (10) with first transfer function K_{A}(s) , comprising:
   - a comparator (01), comparing the output signal Sy of, via first feedback filter Hosc (06) with local input voltage SKin, said comparator
   - a Class D power stage (03), being coupled to and driven by the output of said comparator (01), converting the output voltage of said comparator to a higher voltage level with high current capability
   - a second order lowpass output filter (04) comprising an inductor and a capacitor (04), coupled between the power stage (03) and the loudspeaker or comparable load, for removing at least part of high frequency switching noise from the output signal of said Class D power stage;
   - a time delay unit (02) , said time delay unit being configured to provide a time delay in accordance with one or more of said comparator, Hosc and said power stage;
   - a first feedback path from device output Y, coupling output signal Sy, via Hosc (06), back to the comparator (01), said first feedback path providing control over the oscillation frequency and providing at least partly, low frequency feedback in to reduce distortion of signals in the audio frequency band;
- a correction stage, comprising:
   - a second feedback path, coupling said output signal Sy from device output Y to a feedback input of said correction stage via H1 (104) to summing node S2, being a virtual ground input of transimpedance amplifier HZ1 (102), for further correcting an error of said output signal (Sy), generated by said amplifier stage, wherein said further correction is performed by pre-distorting the power amplifier input signal SKin of said amplifier stage (10) with an inverse of an isolated and filtered distortion component caused by the power amplifier stage, the output filter, and the loudspeaker or the comparable load, wherein the isolated distortion component is obtained by running the incoming signal Sr through tracking filter K_{T},(101), and subsequently subtracting the result from said feedback signal from the output of H1 (104), being a scaled version of the output signal Sy.

The correction stage further comprises:
- a third feedback path, coupling said output signal Sy to an additional feedback input via H2 + H3, and through HZ2 of said correction stage, to further enhance said correction of said output signal Sy by said second feedback path, wherein said third feedback path is configured as a higher order addition for enhanced selectivity of the feedback path and for providing additional feedback gain, and wherein said third feedback path is comprised of a network that implements a first transfer function H2 applied to the output signal Sy and a second, different, transfer function H3 applied to the input signal Sx, said H2 and H3 being combined within a single passive network comprising resistors and capacitors, and wherein the respective outputs of H2 and H3 are summed and supplied as a current input to a transimpedance amplifier HZ2, the output of which defines the input signal Sr.

An important element in research leading to potential new amplifier designs and eventually the amplifier design of the present invention, was the fact that even more than in previous designs the actual perception of audio quality was a key element. It was an insight that traditional Fourier based distortion measurements have at no point to be considered the only way to judge the performance of the amplifier.

All through the design phase, the inventors had the insight to update the known amplifier designs and subject these to extensive listening tests. Research of the inventors led to a different insight on feedback loop design, in which not so much the highest possible overall feedback loop gain was sole object, but also audible effects of the phase response and gain distribution in the loop system were evaluated.

Key components like operational amplifiers were extensively tested, resulting in small differences in perceived audio quality that could not clearly be explained from the relevant data sheets. This, amongst other reasons lead to the suggestion to use discrete opamps in an example of the present invention.

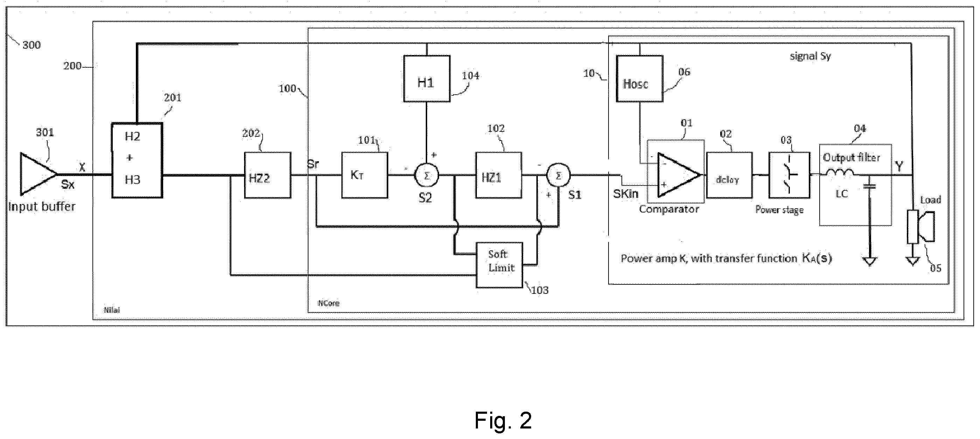

The amplifier device according to this first aspect, and as shown in figure 2 and denoted with reference 300 may be denoted with three different blocks, identified as:
- the self-oscillating power amplifier device 10;
- the power amplifier, which is enhanced with the first generation correction loop (100);
- the power amplifier, which is further enhanced with a second generation, higher order correction loop system (200).

The fist block, 10, i.e. the self oscillating Class D power amplifier stage has a first transfer function K_{A}(s), and comprises:
- a comparator 01, comparing the output signal Sy of, via first feedback filter Hosc 06 with local input voltage SKin, said comparator
- a Class D power stage 03, being coupled to and driven by the output of said comparator 01, converting the output voltage of said comparator to a higher voltage level with high current capability
- a second order lowpass output filter 04 comprising an inductor and a capacitor 04, coupled between the power stage 03 and the loudspeaker or comparable load, for removing at least part of high frequency switching noise from the output signal of said Class D power stage;
- a time delay unit 02, said time delay unit being configured to provide a time delay in accordance with one or more of said comparator, Hosc and said power stage;
- a first feedback path from device output Y, coupling output signal Sy, via Hosc 06, back to the comparator 01, said first feedback path providing control over the oscillation frequency and providing at least partly, low frequency feedback in to reduce distortion of signals in the audio frequency band.

The first feedback path may in an example periodically update the output level of the comparator 01 and forcing the output filter 04 to integrate Sy closer to the exact value it should have at the time of switching. The skilled person will appreciate that, since the actual output level at the output of 03 is only updated at certain instants defined by the switching frequency, the constantly integrating voltage Sy at device output Y will always still have a small error.

Please note that 10 represents the earliest generation of self oscillating class D amplifiers produced and marketed by the present applicant under the brand name UcD. and disclosed in EP3 721 553 B1, and as such is incorporated by reference into the present disclosure to form part of the present invention.

In a second generation of these self-oscillating amplifiers, performance was greatly improved by adding extra error correction in the audio frequency range with an extra feedback loop, adding extra error correction in the audio frequency band with relatively high loop gain, while leaving the oscillation feedback effectively intact. To achieve this goal the following was added to the fist block 10:
- a correction stage, comprising:
   - a second feedback path, coupling said output signal Sy from device output Y to a feedback input of said correction stage via H1 (104) to summing node S2, being a virtual ground input of transimpedance amplifier HZ1 (102), for further correcting an error of said output signal (Sy), generated by said amplifier stage, wherein said further correction is performed by pre-distorting the power amplifier input signal SKin of said amplifier stage (10) with an inverse of an isolated and filtered distortion component caused by the power amplifier stage, the output filter, and the loudspeaker or the comparable load, wherein the isolated distortion component is obtained by running the incoming signal Sr through tracking filter K_{T},(101), and subsequently subtracting the result from said feedback signal from the output of H1 (104), being a scaled version of the output signal Sy.

Hence, the signal coming from S2 is filtered in transimpedance amplifier HZ1, 102. This amplifier serves to vastly amplify the low-frequency error, while preserving the oscillation feedback.

The skilled person is to appreciate that this improvement of the Class D amplifier 100 with this second feedback path comprised in block 100, represents the second generation of self oscillating class D amplifiers produced and marketed by Hypex Electronics under the brand name NCore, and disclosed in EP 2 221 964 B1 and as such is also part of and incorporated by reference into the present disclosure in the form disclosed therein or in a modification thereof. Later on in this document, details on the modifications and their effect resulting in the present invention is mentioned further in the summary and detailed description section. Throughout the figures and block schematic this improvement is denoted as 100.

While block 100 proved to be a vast improvement in both measured and perceived audio reproduction quality, research and testing concluded that there was still room for improvement of audio quality. Further research led to the insight that this further improvement was to be achieved by adding extra low frequency gain in the feedback loop and a higher order transfer function would enable this, which was realized by:
said correction stage to further comprise:
- an addition to the feedback loop structure in the form of an extra signal path into the correction stage via H2 + H3 and HZ2.

H2 and H3 are two different transfer functions combined in a single network, H2 being the feedback transfer from device output Y, while H3 being the feedforward transfer from the device input X, which in an example comes from input buffer 301. The added outputs of both signals Sy and Sx via transfer functions H2 and H3 respectively are fed as current to transimpedance amplifier HZ2 to form signal Sr, being the input signal of block 100. The skilled person will appreciate that the extended loop structure formed by H2+H3 and HZ1 should not be considered to be a separate loop, but rather a higher order extension of said correction stage.

Hence, this is reflected in the features of the first aspect of the present invention in the correction stage to further comprise:
- a third feedback path, coupling said output signal Sy to an additional feedback input via H2 + H3, and through HZ2 of said correction stage, to further enhance said correction of said output signal Sy by said second feedback path, wherein said third feedback path is configured as a higher order addition for enhanced selectivity of the feedback path and for providing additional feedback gain, and wherein said third feedback path is comprised of a network that implements a first transfer function H2 applied to the output signal Sy and a second, different, transfer function H3 applied to the input signal Sx, said H2 and H3 being combined within a single passive network comprising resistors and capacitors, and wherein the respective outputs of H2 and H3 are summed and supplied as a current input to a transimpedance amplifier HZ2, the output of which defines the input signal Sr.

The amplifier device 200 is arranged to amplify an input signal Sx such as an analog audio signal at device input X, into an output signal Sy, e.g. an amplified audio signal being a representation of the analog audio signal, the output signal Sy is forwarded to a load (05) at the output of the device, also referred to as device output Y.

At the core of the device is the Class D amplifier stage 10. The amplifier stage consists of several components; the comparator (01), the power stage 03, a low-pass output filter 04 and a first feedback path, feeding device output signal Sy back to an input of the comparator via Hosc 06. The inherent delay 02 is actually a distributed function, made up of design choices in all parts of 10.

The amplifier section K, 10 is arranged for generating an amplified output signal. This is an amplified representation of an a local input signal SKin of said amplifier section. The amplification can be defined according to a first transfer function K_{A}(s).

The output filter is a low-pass filter comprised of an inductor and capacitor 04, which LC filter is located between the output of the power stage 02 and the actual output of the device (Y). The LC filter removes most of the high-frequency switching noise from 03 and as such provides a filtered output of the amplified representation of the input signal SKin of the amplifier section 10. This representation is the actual output signal Sy at the device output Y.

The first feedback path via 06 is primarily responsible for the oscillation frequency, and also for primary feedback of LF audio, be it with limited loop gain. The second and third feedback paths are specifically aimed at vastly improving the loop gain in the audio frequency range, while preserving the positive feedback needed for oscillation of the power stage.

The operation of the feedback path is based on the principle of feedback error correction. It compares the input signal of the amplifier section with the scaled output signal (Sy). Any discrepancies between these two signals are considered to be an error. This error is subsequently isolated, filtered and amplified, and used to correct the output signal (Sy), ensuring that it is an accurate representation of the input signal.

Error isolation can be achieved by subtracting a scaled version of output signal Sy from the local input signal Sr. In the case of a perfect power amplifier, the result of the subtraction should be 0. This scenario is put into effect if the signals to be subtracted in summing point S2 are first subjected to the same transfer function. Since output signal Sy will be multiplied with the transfer function of (10), the reference signal from Sy will have to be multiplied with a copy of the same transfer function. This copy is made in tracking filter K_{T}. Transfer function H1 serves no other purpose than to attenuate the output signal Sy, so now we know that any signal coming from Summing point S2 has to be distortion, at least in the audio frequency band.

The function of HZ1 is to dramatically increase the gain in the audio frequency band, and at the same time not to interfere with the feedback needed for oscillation of the power stage. This can be achieved with a filter of order 2 or 3. Some alternative solutions can be seen in drawings 6A, 6B. These alternatives are different from known T integrators having different characteristics, each with their own sound profile.

In a Class D amplifier according to the present disclosure, the feedback system plays a critical role in the operational characteristics of the amplifier. The feedback system function in self-oscillating amplifiers such as the amplifier of the present invention is twofold, it determines the HF switching frequency and at the same time considerably reduces the LF distortion compared to classic class D amplifiers.

With the amplifier stage 10, which in itself is known, a simple but robust amplifier device is achieved which is able to provide high quality and high fidelity audio signals, but, due to the basic configuration of its internal feedback path via Hocs, 06 also has a relatively low loop gain, resulting in non-optimal distortion cancellation.

To this end, the amplifier stage is provided with a further correction stage.

This correction stage provides an additional, second, feedback path, designed to further enhance the accuracy of the output signal Sy . It does this by subtracting the input signal from a scaled version of the output signal in order to isolate the nonlinear distortion component in the output signal. The transfer function K_{T}(s) is inserted in the input signal to duplicate, in the LF audio frequency range, the linear transfer function K_{A}(s) of the power stage. This means that in case of a perfectly distortion free power stage, the outcome of the subtraction would be equal to 0, or with a real world power stage with load, the subtraction result just contains the error or distortion component.

The distortion component is subsequently filtered in HZ1 and subtracted from the input signal Sr to the power amplifier. This input signal is therefore "pre-distorted" with the inverse of the distortion component caused by the output stage and the (reactive) load. HZ1 is a transimpedance amplifier with high gain at frequencies in the audible range.

This correction stage thus includes a feedback path that couples the scaled output signal Sy to the input of the correction stage via H1, 104. This allows the system to continuously monitor the output signal and make necessary adjustments to further correct any errors generated by the amplifier stage K.

With the second feedback path a substantial improvement has been achieved with respect to the amplifier device with only the amplifier power stage, however, it has been determined by listening tests that such a design is still open to further improvement.

Accordingly, the amplifier device according to the present disclosure comprises a third feedback path to enhance the correction stage and further improve performance, lower distortion and improve loop gain as compared to the known design based on the amplifier stage and first correction stage.

This enhancement is an addition that provides another layer of error correction to further improve the accuracy of the output signal Sy. This stage includes a further feedback path that couples the output signal Sy to the input of the correction stage. This additional, third, feedback path is disposed between the output Y and the input stage of the device, and thus, as seen from input to output, the amplifier comprises a correction stage with a third feedback path and a second feedback path, and the amplifier stage with first feedback path, followed by the LC filter.

The third feedback path is in fact an enhancement of the second feedback path discussed earlier. The higher order transfer function of the combined outer loops enables the loop structure to operate at higher loop gain compared to a lower order solution. Only a single correction signal may be considered to be derived from the loop structure. The whole system may at first sight appear to have several completely independent loops, but in fact operates as a single, higher order loop, enabling improved loop gain through narrowly tailored loop response, and therefore a more accurate correction signal. Hence, the third feedback path provides an additional boost or improvement of error correction, further enhancing the accuracy and fidelity of the output signal. This makes it a distinguishing feature of the amplifier device, particularly in applications where high precision and signal quality are required. The higher order loop filter configuration of the further feedback path allows for higher loop gain and more sophisticated error correction, making this amplifier device highly effective and precise.

In an example the HZ1 filter features at least three capacitors, configured to enable a higher order transfer function compared to earlier designs, thus enabling higher loop gain and improving distortion cancellation and fidelity of the output signal compared to lower order configurations with fewer capacitors in the feedback network. Hence the output signal represents the input signal more faithfully than earlier versions, thereby enhancing the overall audio quality of the amplifier device.

In an example the third feedback path features a passive second order network at the amplifier input, H2 and H3, preferably comprising two capacitors and four resistors, feeding current to the first order transimpedance amplifier HZ2. This passive network features two different transfer functions: one as seen from the input X of the amplifier, and the other one as seen from the feedback signal Sy. Thereby improving the stability of the total feedback structure and maximizing audio quality.

In an example the input signal (Sx) is fed from an input buffer with very low source impedance, wherein said low source impedance buffer is comprised in said amplifier device.

This arrangement ensures that the input signal is fed into the amplifier device with minimal impedance. This is required because the input X features a passive filter network (H2 and H3) of which the transfer function is dependent on the source impedance from its signal source, which should be close to 0 Ohm. The H2 and H3 network adds to improving loop gain, and for that reason can be considered a distinguishing feature.

In an example the third feedback path further comprises a transimpedance circuit HZ2, comprising an opamp, a capacitor, and either one or two resistors. The transimpedance circuit works, in conjunction with the passive network H2 and H3 at input X, as a critical part of the loop structure, enabling a higher loop gain than previous designs. It effectively enhances the higher order transfer function of the feedback system, and as such makes the feedback path more effective in terms of distortion cancellation. Thus, said arrangement enhances the amplifier's ability to accurately reproduce the input signal with minimal distortion, making it suitable for demanding audio applications where high-quality sound reproduction is paramount.

In an example the amplifier device further comprises a clamp circuit, having one input coupled to the input of HZ1, and another input coupled to the input of HZ2, and an output coupled to the output of HZ1.

The soft limiter (103) block compares the isolated error signal from (102) with a pre-determined, fixed voltage. Since said error signal can, under normal operation, expected to be small, this is a viable way to evaluate if the amplifier is working within normal operating limits. The error signal may exceed the expected maximum level due to, for instance, clipping of the amplifier or severe underload. In these cases, the feedback gain of the correction loop will be proportionally scaled back. This approach was evaluated by listening tests against more drastic ways to disable the loop in said abnormal operating conditions, and found to be the best sounding solution.

In an alternative aspect, there is provided an amplifier device for amplifying an input signal (Sx) at a device input (X) to an output signal (Sy) at a device output (Y), for driving a loudspeaker or a comparable reactive load, the amplifier device comprising:
- a self-oscillating Class D power amplifier stage (10), having a first transfer function KA(s), comprising:
   - a comparator (01) configured to compare a scaled version of the output signal (Sy), received via a first feedback path comprising a filter Hosc (06), with a local input signal (SKin);
   - a Class D power stage (03) coupled to and driven by the output of said comparator (01), arranged to convert the comparator output to a higher-voltage switching output;
   - a second-order low-pass output filter (04) comprising an inductor and a capacitor, coupled between the power stage (03) and the load, configured to attenuate high-frequency switching components in the output signal Sy;
   - a delay unit (02) configured to implement a delay associated with one or more of the comparator (01), the power stage (03), and the filter Hosc (06), said delay being characteristic of the self-oscillating behavior;
   - the first feedback path from the device output (Y), coupling the output signal (Sy) via Hosc (06) to the comparator (01), for determining the oscillation frequency and providing at least low-frequency feedback for distortion reduction;
- a correction stage (100), comprising:
   - a second feedback path coupling the output signal (Sy) to a feedback input of the correction stage via a scaling element H1 (104) to a summing node (S2), being a virtual ground input of a transimpedance amplifier HZ1 (102), the correction stage being configured to pre-distort the input signal SKin based on a distortion signal, said distortion signal being obtained by:
      - applying a tracking filter KT (101) to a reference signal (Sr); and
      - subtracting the filtered reference signal from the scaled output signal from H1 (104); the correction stage (100) further comprising (200):
   - a third feedback path, comprising:
      - a passive network including at least resistors and capacitors, configured to apply:
      - a first transfer function H2 to the output signal Sy from the device output (Y); and
      - a second, different transfer function H3 to the input signal Sx from the device input (X);
   and wherein the respective outputs of H2 and H3 being summed in the current domain and supplied to a virtual ground input of a transimpedance amplifier HZ2, said transimpedance amplifier being configured to generate the reference signal Sr.

In an example of the first or second aspect, said third feedback path comprises a combined feedback network configured to apply:
- a first transfer function H2 to the output signal Sy from the device output Y, and
- a second, different, transfer function H3 to the input signal Sx from the device input X.

In an example of the first or second aspect, said transfer functions H2 and H3 are defined to be different in magnitude and/or phase over at least part of the audio frequency range.

In an example of the first or second aspect, said feedback network is arranged to deliver a current, representing the sum of the signals processed through said transfer functions H2 and H3, to a virtual ground input of a transimpedance amplifier HZ2.

In an example of the first or second aspect, an output of said transimpedance amplifier HZ2 is coupled to an input of a tracking filter KT configured to emulate a transfer function of the amplifier stage.

In an example of the first or second aspect, said feedback network implementing H2 and H3 comprises passive components including at least resistors and capacitors.

In an example of the first or second aspect, said feedback network comprises four resistors and two capacitors arranged to define said transfer functions H2 and H3.

In an example of the first or second aspect, the transfer function H2 comprises a first RC filter defined by a first resistor and a first capacitor connected to receive the output signal Sy, and the transfer function H3 comprises a second RC filter defined by a second resistor and a second capacitor connected to receive the input signal Sx, and wherein the outputs of said first and second RC filters are summed in the current domain and provided to the virtual ground input of said transimpedance amplifier HZ2.

### Brief description of the drawings

The invention will further be described by means of specific, nonlimiting, embodiments thereof with reference to the enclosed drawings, wherein:
Figure 1 discloses schematically a self-oscillation class D amplifier device known from prior art;
Figure 2 schematically discloses a self-oscillating class D amplifier device according to an aspect of the present disclosure;;
Figure 3 discloses a detail of H2/H3, according to an aspect of the present disclosure;
Figure 4a and 4b disclose details of two alternatives of HZ2, according to an aspect of the present disclosure;
Figure 5 discloses a detail of H1 according to an aspect of the present disclosure;
Figure 6a and 6b disclose details of two alternatives of HZ1 according to an aspect of the present disclosure.
Figures 7a and 7b disclose details of two alternatives of the soft limiter.

### Detailed description of the drawings

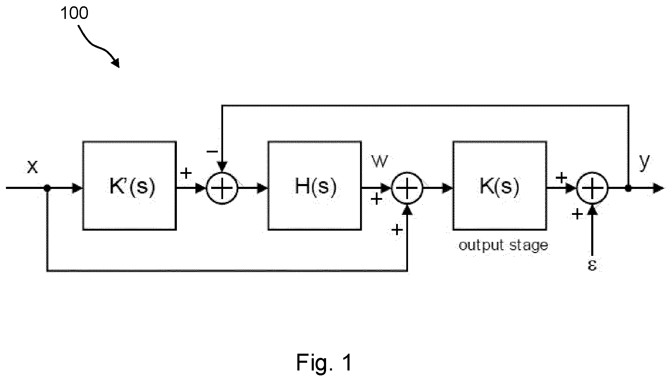

In figure 1 there is shown a basic configuration of a self-oscillating class D amplifier device known from prior art, and marketed by the applicant of the present disclosure as NCore. The amplifier device is comprised of three main components, denoted as transfer functions K(s), H(s) and K'(s). K(s) is the transfer function of the self-oscillating output stage, K'(s) is the transfer function of a linear tracking filter with a copy of said transfer function K(s) of output stage K, but without the nonlinear distortion of K.

The input signal Sx is input at node X and is led via direct forward path to summing node W where the signal is combined with the signal coming from filter H(s), and provided to output stage K. The output stage has a transfer function K(s) and adds a (usually small) disturbance ε to the actual output signal Sy. The actual device output signal Sy enters the control loop from output node Y to the first summation unit disposed between K' and HZ, i.e. from device output Y back towards said first summation unit. This control loop, with the forward filter H(s), significantly increases the (Low Frequency) loop gain of the amplification device.

A lead-lag compensation, together with zero-crossing detector and output filter Hout creates a self-oscillating amplification unit with a well-defined gain and transfer function K(s). The skilled person will appreciate that the internal configuration and operation of the power amplifier stage (10) are in themselves known and do not form part of the inventive concept described herein. A schematic representation is provided in block (10) of Figure 2, while further details may be found in amplifier systems as demonstrated in US 7,113,038 B2 and EP 2 221 964 B1.

In the amplifier device as shown, a tracking filter K' with transfer function K'(s) and subsequent summation unit serve to isolate the distortion component ε originating from power stage K and its load.

K' receives input signal Sx from device input node X. Since transfer function K'(s) mimics the transfer function K(s) of the power stage K, the output of tracking filter K'(s) is an idealized version of Sy without the error term ε. The first, leftmost subtraction unit subtracts the output signal Sy from the idealized version coming from the tracking filter detection filter from the signal received via control loop. Therefore, the forward filter H(s) only receives the (inverted) disturbance ε, i.e. the difference between the signal received via the control loop and the signal received from detection filter. The disturbance ε is under normal conditions considered small, and therefore the output of forward filter will be small as well. H(s) is a precisely configured lowpass function and amplifier, designed and configured to maximize gain in the audio frequency band, and at the same time preserve the right condition for oscillation . In summing node W, the isolated and inverted error is added to the input signal of K(s), thus pre-distorting the input signal with the inverse of the distortion component of K and its load. In an embodiment, Tracking filter K' is implemented as a straightforward RC filter.

In figure 2 an amplifier device (300) is shown according to an embodiment of the present disclosure. The device (300) may be denoted with three different blocks, identified as:
- the self-oscillating power amplifier device (10);
- the power amplifier, which is enhanced with the first generation correction loop (100);
- the power amplifier, which is further enhanced with a second generation, higher order correction loop system (200).

The figure may be interpreted and described best from right to left, as this best illustrates the evolution of the technology. Three red boxes can be identified, each with a title roughly encompassing a particular technological development phase. These are UcD 10, NCore 100, and Nilai 200. Newer generations continually build upon previous ones, with each technological phase forming a subset of the latest development.

Regarding the amplifier stage UcD, this is not yet a real high-end amplifier, but may provide remarkably good performance with relatively simple technology. The entire amplifier can be considered as a comparator capable of delivering a lot of current, followed by a simple LC low-pass filter and a feedback mechanism. The LC filter 04 vastly attenuates the pulse-width signal's high-frequency components from 03, leaving a low-frequency signal for the speaker. This LF signal is fed back to the comparator's input (via Hosc) and scaled before being compared with the input signal. Based on this comparison's outcome, the comparator's state is adjusted to integrate the output signal in the correct direction to reduce the difference between The scaled output signal Sy and local input signal SKin. With some imagination, the operation of the comparator 01, LC filter 04, and feedback can be considered as a linear amplifier with feedback. The LC filter at the output (with load), the feedback network, and the comparator itself introduce a certain delay in the described control loop. This delay determines the switching frequency of the self-oscillating system, roughly 500 kHz without input signal. Additionally, the switching frequency will vary depending on the actual state of the audio signal, decreasing at higher excursions. The strengths of UcD 10 are mainly simplicity and robustness, but the simple control loop has limited gain and, for that reason, is not uncompromising in terms of sound quality.

In the next block, Ncore 100, an additional control loop is provided via H1 104. Blocks 101 and 102 are also added. The strategy here is to isolate the low frequency distortion component of the UcD part (also referred to as K 10 in the block diagram) and subtract it from the input signal (from R) to cancel out distortion. The input signal of the power stage 10 is thus "pre-distorted" with the inverse its own distortion. The output signal Y is fed back via H1 104 to be summed at summing point S2 with the inverse of the signal from 101. The local input signal Sr is thus subtracted, after being filtered in 101, from the scaled output signal Y. 104 is merely a resistor responsible for the correct attenuation of Sy, while 101 is a filter network that attempts to mimic the transfer function of the UcD part 10 as accurately as possible. Therefore, if 10 were to provide perfect transfer, i.e., generate no distortion, the result of this subtraction would always be 0. However, in practice, the isolated distortion component of 10 will emerge here. 102 is a precisely configured transfer function and gain stage, providing high gain in the audio band, while preserving the oscillation condition for 10. we only want to subtract the low-frequency part of the error from the input signal and optimize loop gain in the audio passband. "HZ" indicates that this is a transimpedance circuit, with a virtual ground as input, so it can be easily used as a summing point.

Next, in S1, the input signal to power stage 10 is pre-distorted with the inverse of its isolated and filtered error by subtracting the error from input signal Sr. The degree to which it succeeds in isolating the distortion component exactly depends on good tracking of 101 with 10, and on the loop gain in the outer loop that can be obtained without compromising stability. In theory, this means the higher the gain, the better. Although the 102 function already existed in NCore, this function underwent a modification for Nilai and became slightly more complex than the variant existing in NCore. For details, see drawings 6A and 6B in the drawings section.

NCore was a significant improvement over UcD, but for high-end aspirations, a further improvement was deemed desirable and possible. This is achieved by further increasing the loop gain of the control loop. For this purpose, 201 and 202 are added. 202 is again a transimpedance amplifier. H2 and H3 201 may be interpreted as separate blocks, however, since both are combined in the same passive network, they are shown as a single block with two inputs; one of them is the actual amplifier input, and the other receives the amplifier's output signal for feedback. The circuit features a different transfer function in either signal path.

The open-loop response is that of a finely tuned low-pass filter, while the closed-loop response in the audio band is all-pass, but it does add phase margin in the control loop, allowing for more gain without risking the entire circuit oscillating at an undesired frequency. The entire structure that emerges now functions as a complex control loop that must be designed and evaluated as a whole. The output of 102 is the point where the correction signal is available in the form of the isolated and inverted distortion component. AI circuitry leading up to the loop input of S1 can be considered as a single outer loop with a single loop transfer function. While the block schematic in figure 2may suggest a separate second feedback loop via 104, and a third feedback loop via 201, the whole construction can be seen as as a single, higher order correction loop with summing point S1 as the actual point where the distortion component of 10 is canceled. The circuitry in 201 and 202 governs the overall feedback in the amplifier device, and adds extra feedback gain. It appeared from listening tests, that a careful distribution in loop gain among 102 and 201 was of great influence on the perceived sound quality. Dimensioning these blocks was therefore an important part of the design philosophy.

Amplifier block 200 comes with a soft limiter circuit 103. Two different embodiments of this level detection circuit can be found in drawings 7a and 7b. The circuit is beneficial to keep the high gain feedback loop system from overreacting to undesired operating conditions, like clipping or severe under loading of the power stage 10.

Some amplifiers use hard clip detection at the power amplifier to disable the feedback system completely. In (200) the choice was made to monitor the isolated error at the output of 102 instead. Since in normal operation the signal level at this point is only small, a viable solution is to compare the error signal with a pre-detemined fixed voltage. If the error voltage suddenly exceeds this expected maximum, the circuit will proportionally limit the gain in HZ1 and HZ2 in a tracking fashion. Listening tests performed at high sound levels appeared to sound more "relaxed" with this type of limiting, than with the hard limiting method.

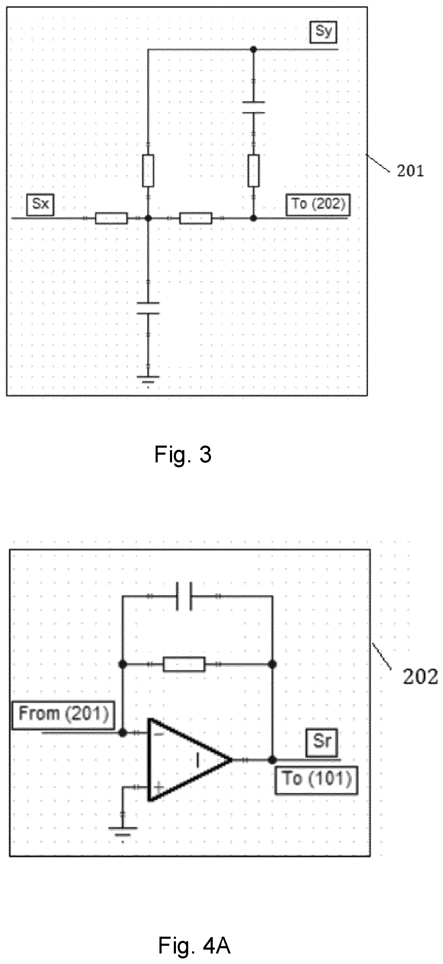

Figure 3 shows filter network 201. Together with transimpedance amplifier 202, the circuit governs overall feedback in the amplifier, and adds extra low frequency loop gain to cancel distortion components effectively. The network consists of 2 capacitors and 4 resistors and enables 2 transfer functions in the same circuit, one in the feedback loop system, and another one feedforward from the input X. Signal Sx is fed from input buffer 301, and has low impedance.

Figure 4A shows an embodiment of transimpedance amplifier 202. This configuration is a first order lowpass filter with virtual ground current input, meant to work in conjunction with 201.

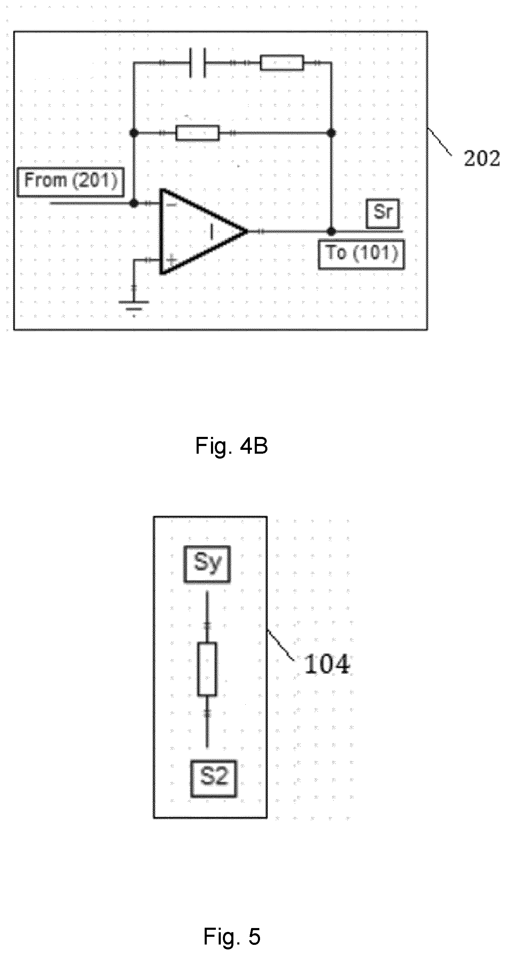

Figure 4B is another embodiment of 202, now featuring a shelving filter function

Figure 5 shows the schematic of H1 104. This is just a resistor, meant to correctly scale the feedback signal from device output Y to summing point S2, being a virtual ground.

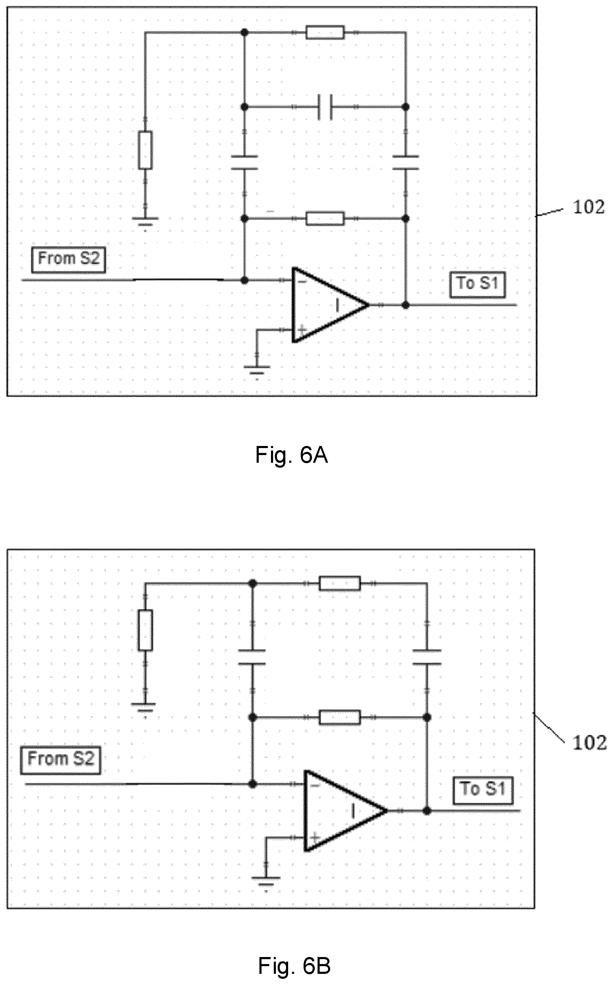

Figure 6A shows an embodiment of transimpedance amplifier HZ1 102. This variety features an opamp, 3 resistors and 3 capacitors.

Figure 6B shows another embodiment of the same circuit 102, now with the middle capacitor deleted. The effect of that capacitor in the practical circuit was very small, and only notable at very high frequencies. Eventually, it was decided that the part could be omitted altogether with no notable effect on overall loop performance. Key to this was the tuning of the circuitry in 201 and 202.

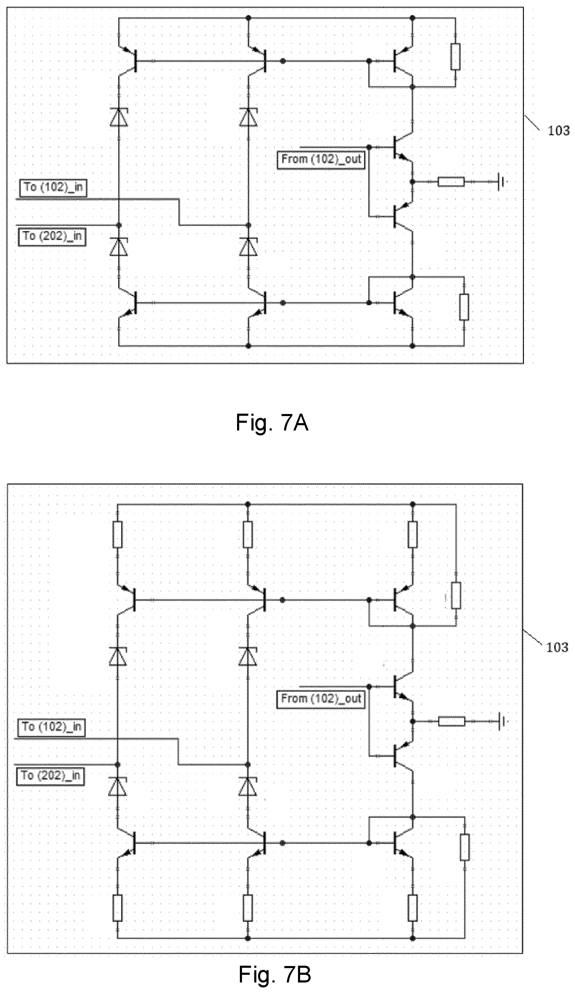

Figure 7A shows an embodiment of the level detector in 103. If the input signal, coming from the output of 103, exceeds a pre-determined voltage level, the circuit will feed current into virtual ground inputs of 102 an 202 in a proportional manner, thus limiting the gain of the loop.

Figure 7B shows a second embodiment o the same circuit 103, but the extra resistors added in the emitters of the transistors give more control over the soft limiting behavior of the circuit.

## Claims

1. An amplifier device for amplifying an input signal Sx at a device input X to an output signal Sy at a device output Y, for driving a loudspeaker or a comparable reactive load, said amplifier device comprising:
- a self oscillating Class D power amplifier stage (10) with first transfer function K_{A}(s) , comprising:
- a comparator (01), comparing the output signal Sy of, via first feedback filter Hosc (06) with local input voltage SKin, said comparator
- a Class D power stage (03), being coupled to and driven by the output of said comparator (01), converting the output voltage of said comparator to a higher voltage level with high current capability
- a second order lowpass output filter (04) comprising an inductor and a capacitor (04), coupled between the power stage (03) and the loudspeaker or comparable load, for removing at least part of high frequency switching noise from the output signal of said Class D power stage;
- a time delay unit (02) , said time delay unit being configured to provide a time delay in accordance with one or more of said comparator, Hosc and said power stage;
- a first feedback path from device output Y, coupling output signal Sy, via Hosc (06), back to the comparator (01), said first feedback path providing control over the oscillation frequency and providing at least partly, low frequency feedback in to reduce distortion of signals in the audio frequency band;
- a correction stage, comprising:
- a second feedback path, coupling said output signal Sy from device output Y to a feedback input of said correction stage via H1 (104) to summing node S2, being a virtual ground input of transimpedance amplifier HZ1 (102), for further correcting an error of said output signal (Sy), generated by said amplifier stage, wherein said further correction is performed by pre-distorting the power amplifier input signal SKin of said amplifier stage (10) with an inverse of an isolated and filtered distortion component caused by the power amplifier stage, the output filter, and the loudspeaker or the comparable load, wherein the isolated distortion component is obtained by running the incoming signal Sr through tracking filter K_{T},(101), and subsequently subtracting the result from said feedback signal from the output of H1 (104), being a scaled version of the output signal Sy;
said correction stage further comprising:
- a third feedback path, coupling said output signal Sy to an additional feedback input via H2 + H3, and through HZ2 of said correction stage, to further enhance said correction of said output signal Sy by said second feedback path, wherein said third feedback path is configured as a higher order addition for enhanced selectivity of the feedback path and for providing additional feedback gain, and wherein said third feedback path is comprised of a network that implements a first transfer function H2 applied to the output signal Sy and a second, different, transfer function H3 applied to the input signal Sx, said H2 and H3 being combined within a single passive network comprising resistors and capacitors, and wherein the respective outputs of H2 and H3 are summed and supplied as a current input to a transimpedance amplifier HZ2, the output of which defines the input signal Sr.

2. The amplifier device according to claim 1, wherein said second feedback path comprises a feedback network of minimum order 2, preferably 3, with at least two capacitors, and preferably three, more preferably four capacitors, and three resistors, more preferably four resistors, configured to enhance error correction and further increase low frequency loop gain.

3. The amplifier device according to claim 1 or 2, with the third feedback path further comprising an input/feedback summation function via summing network H2 + H3 comprising capacitors and resistors, configured to add input signal Sx and output signal Sy feedback from the output (Y) in a frequency-dependent manner, wherein the summed output being fed as current to the virtual ground input of transimpedance amplifier HZ2.

4. The amplifier device according to claim 3, wherein said summation function further comprises a transimpedance circuit HZ2, comprising an opamp, either one or two resistors and a capacitor.

5. The amplifier device according to any of the previous claims, further comprising a soft limiter circuit, having an input coupled to the output of (102) and an output coupled to an input of HZ1(s) and another output coupled to an input of HZ2(s) effectively proportionally limiting the gain of the correction loop structure if the voltage level at the output of HZ1 (102) exceeds a predetermined voltage level.
